# EUROPEAN PATENT SPECIFICATION

(11) **EP 3 422 249 B1**
(45) Date of publication and mention of the grant of the patent: **08.09.2021**
(21) Application number: 17900280.3
(22) Date of filing: 20.04.2017
(51) Int. Cl.: G06K 9/00

(54) **BIOMETRIC IDENTIFICATION DEVICE AND MANUFACTURING METHOD FOR A PROTECTIVE COVER PLATE**
BIOMETRISCHE IDENTIFIZIERUNGSVORRICHTUNG UND HERSTELLUNGSVERFAHREN FÜR EINE SCHUTZABDECKUNGSPLATTE
DISPOSITIF D'IDENTIFICATION BIOMÉTRIQUE ET PROCÉDÉ DE FABRICATION D'UNE PLAQUE DE COUVERTURE PROTECTRICE

(43) Date of publication of application: 02.01.2019
(73) Proprietor: Shenzhen Goodix Technology Co., Ltd., Shenzhen, Guangdong 518045 (CN)
(72) Inventor: GUO, Yiping, Shenzhen, Guangdong 518045 (CN); LI, Shaojia, Shenzhen, Guangdong 518045 (CN)
(74) Representative: Pfenning, Meinig & Partner mbB
(86) International application number: PCT/CN2017/081179
(87) International publication number: WO 2018/191901

(56) References cited:
- CN-A- 104 700 079
- CN-A- 105 224 934
- CN-A- 105 528 568
- CN-A- 106 487 962
- CN-A- 106 487 962
- CN-A- 107 077 611
- US-A1- 2014 241 595

## Description

### TECHNICAL FIELD

The present invention relates to the field of biometric recognition, and more specifically, to a biometric recognition apparatus and a method of manufacturing a protection cover plate.

### BACKGROUND

At present, with the development of biometric recognition technologies, especially the rapid development of fingerprint recognition technologies, consumers use biometric recognition sensors more and more frequently, and put forward a higher requirement on the recognition ability of the biometric recognition sensors at the same time. How to improve the recognition ability of the biometric recognition sensors is a hot research topic in the art.

In addition, US 2014/0241595 A1 relates to an integrated finger print sensor. Specifically, this disclosure generally provides a fingerprint sensor and fingerprint sensor system especially for integration in a device having an overlay made of an insulating material comprises a plurality of sensing elements positioned on a first side of the overlay; a plurality of probes positioned in a predetermined pattern defining a fingerprint sensing area on a second side of the overlay, the plurality of probes extending from the first side of the overlay at least partially through the overlay; a plurality of conductor leads on the first side of the overlay interconnecting the plurality of probes with the plurality of sensing elements; a plurality of amplifiers connected to the plurality of sensing elements, the number of amplifiers being less than the number of sensing elements; and an activation circuit connected to the plurality of sensing elements, the activation circuit being adapted to output at least one activation signal.

### SUMMARY

The scope of the invention is defined by the appended set of claims.

### BRIEF DESCRIPTION OF DRAWINGS

FIG. 1 is a schematic diagram of a biometric recognition apparatus applied in an embodiment of the present invention.
FIG. 2 is a schematic diagram of a protection cover plate provided in an embodiment of the present invention.
FIG. 3 is a schematic diagram of an example of a biometric recognition apparatus provided in an embodiment of the present invention.
FIG. 4 is a schematic diagram of an example of a protection cover plate provided in an embodiment of the present invention.
FIG. 5 is a schematic diagram of another example of a protection cover plate provided in an embodiment of the present invention.
FIG. 6 is a schematic diagram of electric field distribution of a capacitive fingerprint recognition sensor being touched by a finger provided in an embodiment of the present invention.
FIG. 7 is a schematic diagram of a light path of an optical fingerprint recognition sensor being touched by a finger provided in an embodiment of the present invention.
FIG. 8 is a schematic flowchart of a method of manufacturing a protection cover plate provided in an embodiment of the present invention.

### DESCRIPTION OF EMBODIMENTS

Technical solutions in embodiments of the present invention will be described below with reference to the accompanying drawings in the embodiments of the present invention.

It should be understood that a technology disclosed herein may be used for securing access to various electronic devices and systems, including portable or mobile computing devices such as laptops, tablets, smartphones, and gaming devices, and other electronic devices or systems such as electronic databases, automobiles, and bank ATMs.

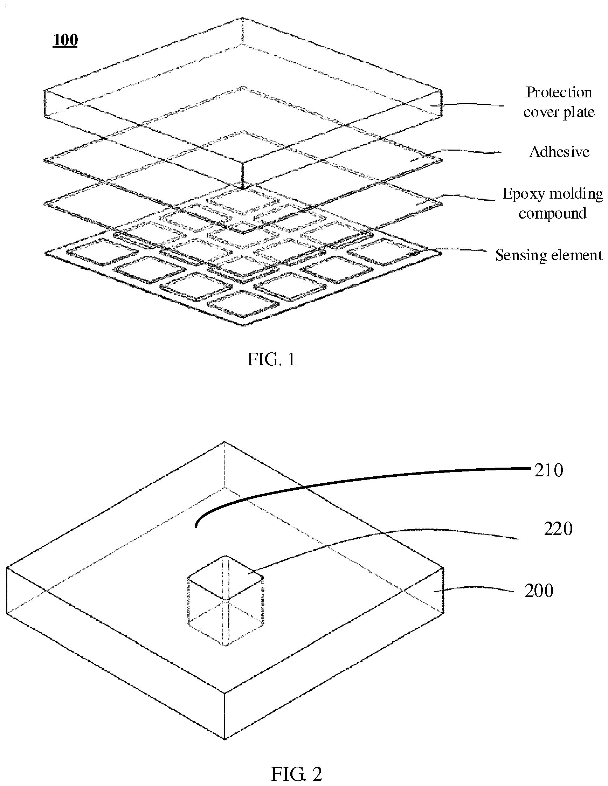

FIG. 1 is a structure of a typical fingerprint recognition module 100. Referring to FIG. 1, the fingerprint recognition module 100 includes: a sensing element (which may also be referred to as a detection element), an epoxy molding compound, an adhesive and a protection cover plate, where the sensing element is used for capturing a fingerprint pattern. It can be seen from FIG. 1 that a user's finger is not in direct contact with the sensing element when touching the fingerprint recognition module. The presence of an intermediate dielectric layer will inevitably result in that the coupling efficiency of the fingerprint recognition module is attenuated to some degree, such that some feature points of a fingerprint of the finger cannot be collected by the sensing element well, thus making the recognition ability of the fingerprint recognition module limited.

FIG. 2 shows a protection cover plate 200 provided in an embodiment of the present invention. The protection cover plate 200 is applied to a biometric recognition apparatus, where the biometric recognition apparatus includes N detection elements, N being an integer greater than or equal to 1. The biometric recognition apparatus is a fingerprint recognition apparatus, for example, a capacitive fingerprint recognition apparatus or an optical fingerprint recognition apparatus, etc. As an example, the protection cover plate 200 may be applied to the fingerprint recognition module 100 as shown in FIG. 1, but the embodiment of the present invention is not limited to this.

Specifically, in the biometric recognition apparatus, the protection cover plate is located above the N detection elements. As an alternative embodiment, the biometric recognition apparatus may further include an adhesive between the protection cover plate and the N detection elements. As another alternative embodiment, the biometric recognition apparatus may further include an epoxy molding compound between the adhesive and the N detection elements, but the embodiment of the present invention is not limited to this.

As shown in FIG. 2, the protection cover plate 200 includes: a first area 210 and a second area 220, where a thickness of the second area 220 is greater than a first threshold, and a target parameter of the second area 220 is different from that of the first area 210, where the target parameter includes one or more of the following parameters: a dielectric constant, a light transmittance and a light refractive index.

One or more parameters in a dielectric constant, a light transmittance and a light refractive index of the first area and the second area may be different. Optionally, both the first area and the second area may be three-dimensional stereoscopic areas, where a thickness of the second area is greater than a first threshold, for example, a thickness of the second area may be equal to that of the protection cover plate, or a thickness of the second area may be greater than the first threshold and less than the thickness of the protection cover plate. In an embodiment of the present invention, a thickness of the protection cover plate may be tens of microns to few millimeters, which is not limited in the embodiment of the present invention. In addition, the second area may be in any shape. Optionally, projection of the second area on a top surface of the protection cover plate may be rectangular, or circular, or in another shape, and the second area may be a cylinder, a cuboid or another shape, but the embodiment of the present invention does not make any limitation to a shape of the second area and a shape of the projection of the second area on the top surface of the protection cover plate.

In an embodiment of the present invention, the first area and the second area are obtained by processing the same protection cover plate base, that is, the first area and the second area have the same material, but have different molecule arrangement structures. Optionally, the protection cover plate base may be glass, but the embodiment of the present invention is not limited to this.

Optionally, the protection cover plate base may include a sensitive medium which may be influenced by light and temperature. After special treatment, the same base material may be changed to form at least two materials with different crystal structures, or with different transmittance and/or refractive index for different visible-light and/or near-infrared.

As an example, the first area and the second area may be manufactured using a template method. As an example, photosensitive composition may be doped into a protection cover plate base, and the photosensitive composition may include salts, oxides or halides, or the like of gold, silver, cerium and the like. A surface (for example, a top surface or a bottom surface) of the protection cover plate base may then be selectively covered with a photomask, and the protection cover plate base is constantly irradiated by ultraviolet light for a period of time. At last, the photomask may be removed, and heat treatment is performed on the protection cover plate base. In this way, after irradiation of the ultraviolet light, a molecule arrangement structure of an uncovered portion of the photomask is changed, such that a physical parameter (for example, one or more of a dielectric constant, a light transmittance and a light refractive index) of this portion is changed. Optionally, a covered portion of the photomask may form a first area, and an uncovered portion of the photomask may form a second area. In addition, a shape, a size and a target parameter of the second area may be adjusted by controlling a shape of a photomask, the irradiation time of ultraviolet light and a conditions of heat treatment, but the embodiment of the present invention is not limited to this.

In this way, an appearance structural member of the protection cover plate may be a complete integral material without the need for performing secondary etching or another precision micro-hole processing, which thus can effectively prevent another foreign material hiding in a second area.

In this way, by providing a first area and a second area of which one or more parameters in a dielectric constant, a light transmittance and a light refractive index are different in a protection cover plate, electric field distribution of a capacitive fingerprint recognition sensor or a light path direction of an optical fingerprint recognition sensor may be changed through an internal structure of the protection cover plate when a finger presses the protection cover plate, thus contributing to improving the coupling efficiency and semaphores, and increasing a fingerprint recognition rate.

As an alternative example, the second area may be disposed corresponding to a detection element in the biometric recognition apparatus, that is, a size and a location of the second area may be corresponding to those of the detection element. Optionally, projection of the second area on a top surface of the protection cover plate may completely or substantially coincide with that of the detection element on the top surface of the protection cover plate; or the projection of the second area may completely or substantially cover that of the detection element; or the projection of the second area may cover a part of the projection of the detection element and an area of an uncovered part of the projection of the detection element does not exceed a certain threshold. In this way, the coupling efficiency of the biometric recognition apparatus may be improved by adjusting a value of a target parameter of the second area, thus improving the recognition ability of the biometric recognition apparatus.

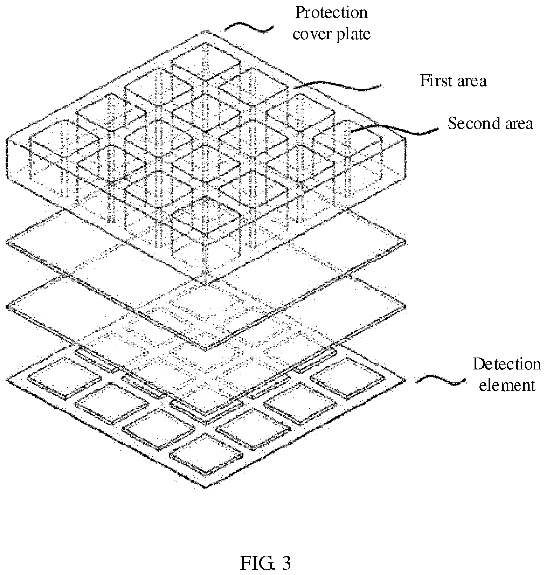

It should be understood that FIG. 2 schematically shows that the protection cover plate includes one first area and one second area. Optionally, the protection cover plate may also include a plurality of second areas and/or a plurality of first areas, where target parameters of any two second areas in the plurality of second areas may be the same or different, which is not limited in the embodiment of the present invention. As an example, the protection cover plate may include M second areas, where M is an integer greater than or equal to 1. Optionally, M may be equal to N or not be equal to N. When M=N, as shown in FIG. 3, the N second areas are disposed in one-to-one correspondence with N detection elements in the biometric recognition apparatus, that is, a size and a location of the second area i in the N second areas are corresponding to those of the detection element i in the N detection elements, but the embodiment of the present invention is not limited to this.

Optionally, a center of the detection element i may be on a central axis of the second area i. Alternatively, a distance between a center of the detection element i and a central axis of the second area i may be less than or equal to a certain threshold, but the embodiment of the present invention is not limited to this.

Optionally, projection of the second area i on a top surface or a bottom surface of the protection cover plate may substantially coincide with that of the detection element i on the top surface or the bottom surface of the protection cover plate, or a difference between a projection area of the second area i on the top surface or the bottom surface of the protection cover plate and that of the detection element i on the top surface or the bottom surface of the protection cover plate may be less than or equal to a second threshold. For example, a difference between a length and/or a width of the projection of the second area i on the top surface or the bottom surface of the protection cover plate and that of projection of the detection element i on the top surface or the bottom surface of the protection cover plate may be less than or equal to 5µm, but the embodiment of the present invention is not limited to this.

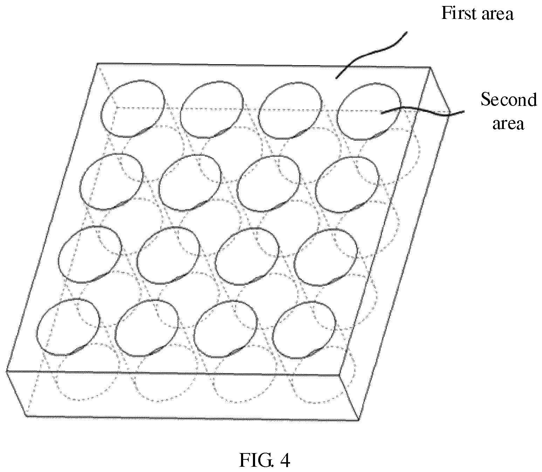

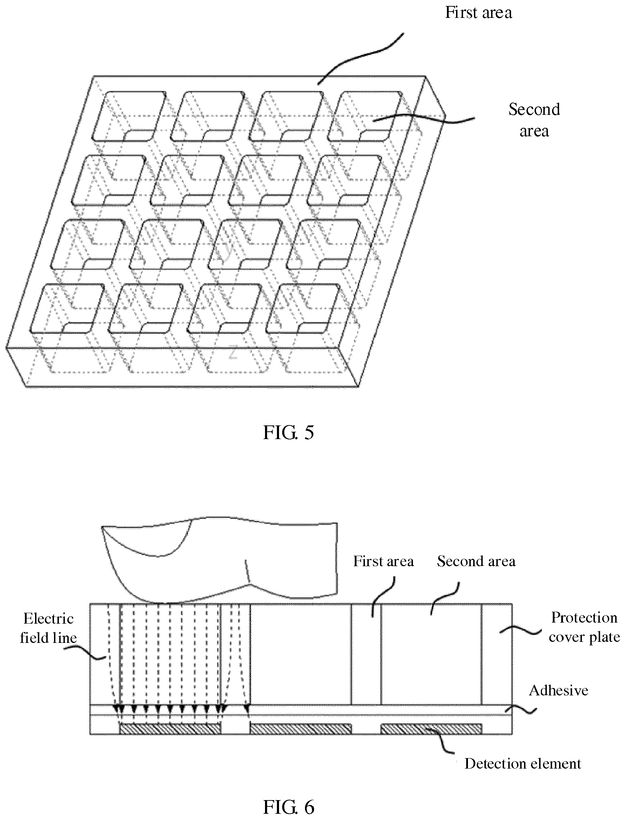

FIGS. 4 and 5 show two examples of the protection cover plate provided in an embodiment of the present invention. In these two examples, the protection cover plate include M second areas which are uniformly distributed and a first area other than the M second areas. The first area may consist of a material A and has dielectric constant ε1, light transmittance T1 and light refractive index n1; and the M second areas may consist of a material B and have dielectric constant ε2, light transmittance T2 and light refractive index n2, where the material A and the material B may have different crystal structures. Optionally, the material A and the material B are the same material, or the material A and the material B may be identical materials, which is not limited in the embodiment of the present invention. Specifically, in the example shown in FIG. 4, all of the M second areas may be in a cylindrical shape, with a thicknesses equal to that of the protection cover plate. In the example shown in FIG. 5, all of the M second areas may be in a cuboid shape, with a thickness equal to that of the protection cover plate, but the embodiment of the present invention is not limited to this.

A biometric recognition apparatus including the protection cover plate in the above embodiment is also provided herein. Specifically, the biometric recognition apparatus includes: N detection units and a protection cover plate located above the N detection units.

Optionally, the biometric recognition apparatus may further include an adhesive between the N detection units and the protection cover plate.

Optionally, the adhesive may be specifically an optically clear adhesive and glue or a glue film in an etching epoxy group, an acrylic acid system and a silica gel system, etc.

As another alternative embodiment, the biometric recognition apparatus may further include an epoxy molding compound, where optionally the epoxy molding compound may be between the adhesive and the N detection units.

Optionally, main composition of the epoxy molding compound may be a transparent epoxy resin filler.

Optionally, the biometric recognition apparatus may further include another element, which is not limited in the embodiment of the present invention.

As an alternative embodiment, the biometric recognition apparatus may be specifically a capacitive fingerprint recognition apparatus, and thus a dielectric constant of the second area may be different from that of the first area. As an example, a dielectric constant of the second area may be lower than that of the first area. In this way, as shown in FIG. 6, an intensity of an electric field generated when a finger touches the capacitive fingerprint recognition apparatus in the second area may be higher than that in the first area, which thus can increase an intensity of a signal received by a detection element and improve the recognition ability of the capacitive fingerprint recognition apparatus.

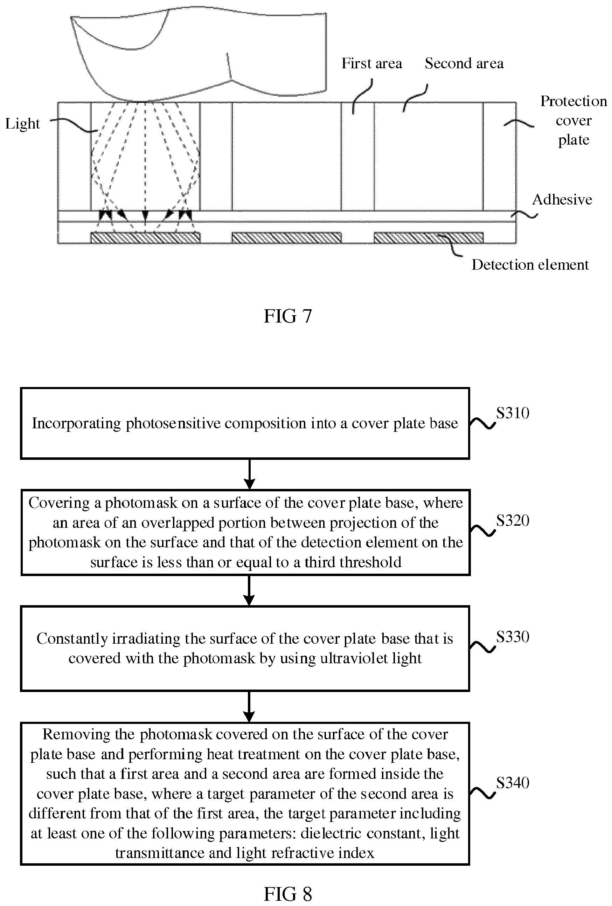

As another alternative embodiment, the biometric recognition apparatus may be specifically an optical fingerprint recognition apparatus, and thus light transmittance and/or light refractive index of the second area may be different from those/that of the first area. As an example, as shown in FIG. 7, light transmittance and/or light refractive index of the second area may be higher than those/that of the first area. In this way, an intensity of light reaching the detection element may be increased, which improves the light coupling efficiency and then improves the recognition ability of the capacitive fingerprint recognition apparatus.

It should be understood that the examples shown in FIGS. 4-7 are for helping a person skilled in the art to better understand the embodiments of the present invention, rather than for limiting the scope of the embodiments of the present invention. It is apparent that a person skilled in the art may make, according to the examples given above, various equivalent modifications or changes which also fall within the scope of the embodiments of the present invention.

Therefore, the biometric recognition apparatus provided in an embodiment of the present invention contributes to improving the coupling efficiency and the recognition ability of a biometric recognition apparatus by providing a first area and a second area in a protection cover plate, where a dielectric constant, a light transmittance and a light refractive index of the second area may be different from those of the first area, and the second area is disposed corresponding to a detection element in the biometric recognition apparatus.

The protection cover plate and the biometric recognition apparatus provided in embodiments of the present invention are introduced above in detail with reference to FIGS. 1-7, and a method of manufacturing a protection cover plate provided in an embodiment of the present invention is introduced below in detail with reference to FIG. 8.

FIG. 8 shows a schematic flowchart of a method 300 of manufacturing a protection cover plate provided in an embodiment of the present invention.

S310, photosensitive composition is incorporated into a cover plate base.

The photosensitive composition may be chemical composition relating to photosensitivity, for example, salts, oxides or halides or the like of gold, silver and cerium, such that the cover plate base has photosensitivity. Optionally, the cover plate base may be specifically glass, but the embodiment of the present invention is not limited to this.

S320, a photomask is covered on a surface of the cover plate base, where an area of an overlapped portion between projection of the photomask on the surface and that of the detection element on the surface is less than or equal to a third threshold.

Optionally, the photomask may be in a rectangular or a circular shape, or another shape, which is not limited in the embodiment of the present invention. Optionally, one or more photomasks may be covered on a surface of the cover plate base, which is not limited in the embodiment of the present invention.

Optionally, projection of the photomask may not overlap that of the detection element at all, or may merely overlap that of the detection element partially, and a value of a third threshold may depend on a shape and a size of a target second area, which is not limited in the embodiment of the present invention.

S330, the surface of the cover plate base that is covered with the photomask is constantly irradiated by using ultraviolet light.

The surface of the cover plate base may be irradiated using an ultraviolet lamp. An irradiation duration may be determined according to a shape and a size of the target second area.

S340, the photomask covered on the surface of the cover plate base is removed, and heat treatment is performed on the cover plate base, such that a first area and a second area are formed inside the cover plate base, where a target parameter of the second area is different from that of the first area, the target parameter including at least one of the following parameters: a dielectric constant, a light transmittance and a light refractive index.

Optionally, after heated at a high temperature, a portion irradiated by the ultraviolet light may generates a phenomenon of crystallization (i.e., ceramization), and accordingly a physical parameter of this portion is changed correspondingly, which may correspond a second area. Accordingly, a portion covered with the photomask is not irradiated by the ultraviolet light, and thus a molecule structure and a physical parameter of this portion may remain unchanged, which may correspond to a first area, but the embodiment of the present invention is not limited to this.

Optionally, in an embodiment of the present invention, by adjusting one or more parameters in different lighting wavelengths, heating temperatures and heating time, different physical parameters of a second area may be obtained, and the distribution shape and size of the second area may be precisely controlled.

In this way, an appearance structural member of a manufactured protection cover plate may be a complete integral material without the need for performing etching or micro precision micro-hole processing, which thus can effectively prevent another foreign material hiding in a second area.

It should be understood that, values of sequence numbers of the above-mentioned various processes do not mean an order of execution which should be determined based upon a function and internal logic thereof, rather than setting any limitation to an implementation process of the embodiments of the present invention.

It should be understood that the above descriptions of the embodiments of the present invention focus on emphasizing differences among various embodiments, and identical or similar points which are not mentioned therein may refer to each other, and for concision, they will not be described redundantly herein.

In addition, terms "system" and "network" herein are often used interchangeably. The term "and/or" herein merely describes an association relationship between associated objects, and represents that three relationships may exist, for example, A and/or B may represent three cases: A exists separately, A and B exist simultaneously, and B exists separately. In addition, the character "/" herein generally represents an "or" relationship between two related objects in front of and following the character.

A person of ordinary skill in the art may realize that, units and algorithm steps of various examples described in connection with the embodiments disclosed herein can be implemented by electronic hardware, or a combination of computer software and the electronic hardware. Whether these functions are executed in a manner of hardware or in a manner of software depends on the specific applications and design constraints of the technical solution. A person skilled may implement the described functions by using different methods for each specific application, but this implementation should not be considered to be beyond the scope of the present invention.

A person skilled in the art may clearly understand that, for convenience and simplicity of description, the specific working processes of the system, the apparatus and the units described above may refer to corresponding processes in the foregoing method embodiments, which will not be described redundantly herein.

In several embodiments provided in the present application, it should be understood that, the disclosed system, apparatus and method may be implemented in other manners. For example, the apparatus embodiments described above are merely exemplary, for example, the division of the units is merely a logic function division, and other division manners may exist in practical implementation, for example, a plurality of units or components may be combined or integrated into another system, or some features may be omitted or not executed. From another point of view, the displayed or discussed mutual coupling or direct coupling or communication connections may be indirect coupling or communication connections of apparatuses or units through some interfaces, and may also be a connection in electrical, mechanical or other forms.

The units described as separate parts may be or may not be separated physically, and a component displayed as a unit may be or may not be a physical unit, namely, may be located in one place, or may be distributed on a plurality of network units. Some or all of the units may be selected to achieve the purposes of the solutions in the present embodiments according to actual needs.

In addition, in various embodiments of the present invention, respective functional units may be integrated in one processing unit, or the respective functional units may physically exist separately, or two or more of the units may be integrated in one unit.

If the functional units are implemented in the form of the software functional unit and are sold or used as an independent product, they may be stored in a computer readable storage medium. Based on such an understanding, the technical solution of the present invention substantially, or a part of the present invention making contribution to the prior art, or all of or a part of the technical solution may be embodied in a form of a software product, and the computer software product is stored in a storage medium which includes multiple instructions for enabling a computer device (which may be a personal computer, a server, a network device and the like) to execute all or some of the steps of the methods described in the respective embodiments of the present invention. In addition, the foregoing storage medium includes a variety of media capable of storing program codes, i.e. a USB disk, a mobile hard disk, a read-only memory (ROM, Read-Only Memory), a random access memory (RAM, Random Access Memory), a magnetic disk, an optical disk and the like.

The protection scope of the present invention shall be subject to the protection scope defined by the claims.

## Claims

1. A biometric recognition apparatus, comprising N detection elements and a protection cover plate (200) located above the N detection elements, wherein the biometric recognition apparatus is a fingerprint recognition apparatus, **characterized in that**
the protection cover plate (200) comprises a first area (210) and M second areas (220), wherein a second area i in the M second areas (220) is disposed corresponding to a detection element j in the N detection elements, a thickness of each second area of the protection cover plate (200) in the M second areas (220) is greater than a first threshold, and a target parameter of each second area in the M second areas (220) is different from that of the first area (210), the target parameter comprising one of the following parameters: a dielectric constant, a light transmittance and a light refractive index, wherein both N and M are integers greater than or equal to 1, 1≤i≤M, and 1≤j≤N, wherein N is equal to M, and the M second areas (220) are disposed in one-to-one correspondence with the N detection elements, and i=j, and the first area and the second area have the same material, but have different molecule arrangement structures, and wherein the first area (210) and M second areas (220) are obtained by processing a same protection cover plate base, and the first area (210) and M second areas (220) are different areas of the protective cover plate (200), and both are part of the protective cover plate (200).

2. The biometric recognition apparatus according to claim 1, wherein the second area i in the M second areas (220) being disposed corresponding to the detection element j in the N detection elements comprises:
a center of the detection element j is on a central axis of the second area i; and/or
a difference between a projection area of the detection element j on a top surface of the protection cover plate (200) and that of the second area i on the top surface of the protection cover plate (200) is less than or equal to a second threshold.

3. The biometric recognition apparatus according to any one of claim 1 or 2, wherein the target parameter of the second area (220) being different from that of the first area (210) comprises at least one of the following:
a dielectric constant of the second area (220) is lower than that of the first area (210);
a light transmittance of the second area (220) is higher than that of the first area (210); and
a light refractive index of the second area (220) is higher than that of the first area (210).

4. The biometric recognition apparatus according to any one of claims 1 to 3, wherein the protection cover plate (200) has photosensitive composition, and the first area (210) and the M second areas (220) are formed by performing heat treatment on the protection cover plate (200) after a surface of the protection cover plate (200) is covered with at least one photomask and is irradiated by ultraviolet light.

5. The biometric recognition apparatus according to any one of claims 1 to 4, wherein the biometric recognition apparatus further comprises: an adhesive between the detection elements and the protection cover plate (200).

6. The biometric recognition apparatus according to claim 5, wherein the biometric recognition apparatus further comprises: an epoxy molding compound between the adhesive and the detection elements.

7. A method of manufacturing a protection cover plate (200) which is applied to a biometric recognition apparatus comprising N detection elements, **characterized in that** the method comprises:
incorporating photosensitive composition into a cover plate base;
covering a photomask on a surface of the cover plate base, wherein an area of an overlapped portion between projection of the photomask on the surface and that of the detection element on the surface is less than or equal to a third threshold;
constantly irradiating the surface of the cover plate base that is covered with the photomask by using ultraviolet light; and
removing the photomask covered on the surface of the cover plate base and performing heat treatment on the cover plate base, such that a first area (210) and M second areas (220) are formed inside the cover plate base, wherein a target parameter of the second area (220) is different from that of the first area (210), the target parameter comprising one of the following parameters: a dielectric constant, a light transmittance and a light refractive index, a second area i in the M second areas (220) is disposed corresponding to a detection element j in the N detection elements, a thickness of each second area of the protection cover plate (220) in the M second areas (220) is greater than a first threshold, both N and M are integers greater than or equal to 1, 1≤i≤M, and 1≤j≤N, N is equal to M, and the M second areas (220) are disposed in one-to-one correspondence with the N detection elements, and i=j, and the first area and the second area have the same material, but have different molecule arrangement structures, and the first area (210) and M second areas (220) are different areas of the protective cover plate (200), and both are part of the protective cover plate (200).

## Patentansprüche

1. Biometrische Erkennungsvorrichtung, umfassend N Detektionselemente und eine über den N Detektionselementen befindliche Schutzabdeckplatte (200), wobei die biometrische Erkennungsvorrichtung eine Fingerabdruckserkennungsvorrichtung ist, **dadurch gekennzeichnet, dass**
die Schutzabdeckplatte (200) einen ersten Bereich (210) und M zweite Bereiche (220) umfasst, wobei ein zweiter Bereich i in den M zweiten Bereichen (220) entsprechend einem Detektionselement j in den N Detektionselementen angeordnet ist, eine Dicke jedes zweiten Bereichs der Schutzabdeckplatte (200) in den M zweiten Bereichen (220) größer als ein erster Schwellwert ist, und ein Zielparameter jedes zweiten Bereichs in den M zweiten Bereichen (220) von dem des ersten Bereichs (210) verschieden ist, wobei der Zielparameter einen der folgenden Parameter umfasst: eine Dielektrizitätskonstante, eine Lichttransmittanz und einen Lichtbrechungsindex, wobei sowohl N als auch M ganze Zahlen größer oder gleich 1 sind, 1≤i≤M, und 1≤j≤N, wobei N gleich M ist, und die M zweiten Bereiche (220) in einer eins-zu-eins-Übereinstimmung mit den N Detektionselementen angeordnet sind und i=j, und der erste Bereich und der zweite Bereich das gleiche Material aufweisen, aber unterschiedliche Molekülanordnungsstrukturen aufweisen, und wobei der erste Bereich (210) und M zweite Bereiche (220) erhalten werden durch Verarbeiten einer gleichen Schutzabdeckplattenbasis, und der erste Bereich (210) und M zweite Bereiche (220) verschiedene Bereiche der Schutzabdeckplatte (200) sind, und beide Teil der Schutzabdeckplatte (200) sind.

2. Biometrische Erkennungsvorrichtung nach Anspruch 1, wobei der zweite Bereich i in den M zweiten Bereichen (220) angeordnet entsprechend dem Detektionselement j in den N Detektionselementen umfasst:
eine Mitte des Detektionselements j ist auf einer Mittelachse des zweiten Bereichs i; und/oder
eine Differenz zwischen einem Projektionsbereich des Detektionselements j auf einer oberen Fläche der Schutzabdeckplatte (200) und dem des zweiten Bereichs i auf der oberen Oberfläche der Schutzabdeckplatte (200) ist kleiner oder gleich einem zweiten Schwellwert.

3. Biometrische Erkennungsvorrichtung nach einem der Ansprüche 1 oder 2,
wobei der Zielparameter des zweiten Bereichs (220) verschieden von dem des ersten Bereichs (210) mindestens eine der Folgenden umfasst:
eine Dielektrizitätskonstante des zweiten Bereichs (220) ist niedriger als die des ersten Bereichs (210);
eine Lichttransmittanz des zweiten Bereichs (220) ist höher als die des ersten Bereichs (210); und
ein Lichtbrechungsindex des zweiten Bereichs (220) ist höher als der des ersten Bereichs (210).

4. Biometrische Erkennungsvorrichtung nach einem der Ansprüche 1 bis 3, wobei die Schutzabdeckplatte (200) eine lichtempfindliche Zusammensetzung aufweist und der erste Bereich (210) und die M zweiten Bereiche (220) gebildet werden durch Durchführen einer Wärmebehandlung an der Schutzabdeckplatte (200), nachdem eine Oberfläche der Schutzabdeckplatte (200) mit mindestens einer Fotomaske bedeckt ist und durch Ultraviolettlicht bestrahlt ist.

5. Biometrische Erkennungsvorrichtung nach einem der Ansprüche 1 bis 4, wobei die biometrische Erkennungsvorrichtung weiter umfasst:
ein Haftmittel zwischen den Detektionselementen und der Schutzabdeckplatte (200).

6. Biometrische Erkennungsvorrichtung nach Anspruch 5, wobei die biometrische Erkennungsvorrichtung weiter umfasst: eine Epoxidformteilverbindung zwischen dem Haftmittel und den Detektionselementen.

7. Verfahren zum Herstellen einer Schutzabdeckplatte (200), die auf eine biometrische Erkennungsvorrichtung umfassend N Detektionselemente aufgebracht ist, **dadurch gekennzeichnet, dass** das Verfahren umfasst:
Integrieren einer lichtempfindlichen Zusammensetzung in eine Abdeckplattenbasis;
Legen einer Fotomaske auf eine Oberfläche der Abdeckplattenbasis, wobei ein Bereich eines überlappten Abschnitts zwischen einer Projektion der Fotomaske auf der Oberfläche und dem des Detektionselements auf der Oberfläche kleiner oder gleich einem dritten Schwellwert ist;
konstantes Bestrahlen der Oberfläche der Abdeckplattenbasis, die mit der Fotomaske bedeckt ist, durch Verwenden von Ultraviolettlicht; und
Entfernen der auf die Oberfläche der Abdeckplattenbasis gelegten Fotomaske und Durchführen einer Wärmebehandlung an der Abdeckplattenbasis, so dass ein erster Bereich (210) und M zweite Bereiche (220) innerhalb der Abdeckplattenbasis gebildet werden, wobei ein Zielparameter des zweiten Bereichs (220) verschieden ist von dem des ersten Bereichs (210), der Zielparameter einen der folgenden Parameter umfasst: eine Dielektrizitätskonstante, eine Lichttransmittanz und einen Lichtbrechungsindex, ein zweiter Bereich i in den M zweiten Bereichen (220) ist entsprechend einem Detektionselement j in den N Detektionselementen angeordnet, eine Dicke jedes zweiten Bereichs der Schutzabdeckplatte (220) in den M zweiten Bereichen (220) ist größer als ein erster Schwellwert, sowohl N als auch M sind ganze Zahlen größer oder gleich eins, 1≤i≤M, und 1≤j≤N, N ist gleich M, und die M zweiten Bereiche (220) sind in einer eins-zu-eins-Übereinstimmung mit den N Detektionselementen angeordnet, und i=j, und der erste Bereich und der zweite Bereich weisen das gleiche Material auf, aber haben unterschiedliche Molekülanordnungsstrukturen, und der erste Bereich (210) und die M zweiten Bereiche (220) sind verschiedene Bereiche der Schutzabdeckplatte (220), und beide sind Teil der Schutzabdeckplatte (200) .

## Revendications

1. Appareil de reconnaissance biométrique, comprenant N éléments de détection et une plaque de couverture protectrice (200) disposée au-dessus des N éléments de détection, dans lequel l'appareil de reconnaissance biométrique est un appareil de reconnaissance d'empreintes digitales, **caractérisé en ce que** la plaque de couverture protectrice (200) comprend une première zone (210) et M deuxièmes zones (220), dans lequel une deuxième zone i parmi les M deuxièmes zones (220) est disposée de façon à correspondre à un élément de détection j parmi les N éléments de détection, une épaisseur de chaque deuxième zone de la plaque de couverture protectrice (200) parmi les M deuxièmes zones (220) est supérieure à un premier seuil, et un paramètre cible de chaque deuxième zone parmi les M deuxièmes zones (220) est différent de celui de la première zone (210), le paramètre cible comprenant l'un des paramètres suivants : une constante diélectrique, un facteur de transmission de la lumière et un indice de réfraction de la lumière, où N et M sont tous deux des entiers supérieurs ou égaux à 1, 1≤i≤M, et 1≤j≤N, dans lequel N est égal à M, et les M deuxièmes zones (220) sont disposées en correspondance biunivoque avec les N éléments de détection, et i=j, et la première zone et la deuxième zone comportent le même matériau, mais présentent des structures d'agencement de molécules différentes, et dans lequel la première zone (210) et les M deuxièmes zones (220) sont obtenues par traitement d'une même base de plaque de couverture protectrice, et la première zone (210) et les M deuxièmes zones (220) sont des zones différentes de la plaque de couverture protectrice (200), et font toutes deux partie de la plaque de couverture protectrice (200).

2. Appareil de reconnaissance biométrique selon la revendication 1, dans lequel la deuxième zone i parmi les M deuxièmes zones (220), qui est disposée en correspondance avec l'élément de détection j parmi les N éléments de détection, comprend :
un centre de l'élément de détection j est sur un axe central de la deuxième zone i ; et/ou
une différence entre une zone de projection de l'élément de détection j sur une surface supérieure de la plaque de couverture protectrice (200) et celle de la deuxième zone i sur la surface supérieure de la plaque de couverture protectrice (200) est inférieure ou égale à un deuxième seuil.

3. Appareil de reconnaissance biométrique selon l'une quelconque des revendications 1 ou 2, dans lequel le paramètre cible de la deuxième zone (220), qui est différent de celui de la première zone (210), comprend au moins l'un des éléments suivants :
une constante diélectrique de la deuxième zone (220) est inférieure à celle de la première zone (210) ;
un facteur de transmission de la lumière de la deuxième zone (220) est supérieur à celui de la première zone (210) ; et
un indice de réfraction de la lumière de la deuxième zone (220) est supérieur à celui de la première zone (210).

4. Appareil de reconnaissance biométrique selon l'une quelconque des revendications 1 à 3, dans lequel la plaque de couverture protectrice (200) comporte une composition photosensible, et la première zone (210) et les M deuxièmes zones (220) sont formées par réalisation d'un traitement thermique sur la plaque de couverture protectrice (200) après qu'une surface de la plaque de couverture protectrice (200) a été recouverte d'au moins un photomasque et a été exposée à de la lumière ultraviolette.

5. Appareil de reconnaissance biométrique selon l'une quelconque des revendications 1 à 4, dans lequel l'appareil de reconnaissance biométrique comprend en outre : un adhésif entre les éléments de détection et la plaque de couverture protectrice (200).

6. Appareil de reconnaissance biométrique selon la revendication 5, dans lequel l'appareil de reconnaissance biométrique comprend en outre : un composé de moulage époxy entre l'adhésif et les éléments de détection.

7. Procédé de fabrication d'une plaque de couverture protectrice (200) qui est appliquée à un appareil de reconnaissance biométrique comprenant N éléments de détection, **caractérisé en ce que** le procédé comprend :
l'incorporation d'une composition photosensible dans une base de plaque de couverture ;
l'application d'un photomasque sur une surface de la base de plaque de couverture, dans lequel une zone d'une partie de chevauchement entre la projection du photomasque sur la surface et celle de l'élément de détection sur la surface est inférieure ou égale à un troisième seuil ;
l'exposition constante de la surface de la base de plaque de couverture qui est recouverte du photomasque par utilisation d'une lumière ultraviolette ; et
l'enlèvement du photomasque appliqué sur la surface de la base de plaque de couverture et la réalisation d'un traitement thermique sur la base de plaque de couverture, de façon à ce qu'une première zone (210) et M deuxièmes zones (220) soient formées à l'intérieur de la base de plaque de couverture, dans lequel un paramètre cible de la deuxième zone (220) est différent de celui de la première zone (210), le paramètre cible comprenant l'un des paramètres suivants : une constante diélectrique, un facteur de transmission de la lumière et un indice de réfraction de la lumière, une deuxième zone i parmi les M deuxièmes zones (220) est disposée en correspondance avec un élément de détection j parmi les N éléments de détection, une épaisseur de chaque deuxième zone de la plaque de couverture de protection (220) parmi les M deuxièmes zones (220) est supérieure à un premier seuil, N et M sont tous deux des entiers supérieurs ou égaux à 1, 1≤i≤M, et 1≤j≤N, N est égal à M, et les M deuxièmes zones (220) sont disposées en correspondance biunivoque avec les N éléments de détection, et i=j, et la première zone et la deuxième zone comportent le même matériau, mais ont des structures d'agencement de molécules différentes, et la première zone (210) et les M deuxièmes zones (220) sont des zones différentes de la plaque de couverture protectrice (200), et font toutes deux partie de la plaque de couverture protectrice (200).
